# EUROPÄISCHE PATENTSCHRIFT

(11) **EP 1 530 728 B1**
(45) Veröffentlichungstag und Bekanntmachung des Hinweises auf die Patenterteilung: **17.01.2007**
(21) Anmeldenummer: 03750276.2
(22) Anmeldetag: 18.08.2003
(51) Int. Cl.: G01R 33/28

(54) **VORRICHTUNG UND VERFAHREN ZUR HERSTELLUNG VON HOCH KERNSPINPOLARISIERTEN FLÜSSIGKEITEN**
DEVICE AND METHOD FOR PRODUCING LIQUIDS WITH A HIGH NUCLEAR SPIN POLARISATION
DISPOSITIF ET PROCEDE DE PRODUCTION DE LIQUIDES A HAUTE POLARISATION DE SPIN NUCLEAIRE

(30) Priorität: 19.08.2002 DE 10238637
(43) Veröffentlichungstag der Anmeldung: 18.05.2005
(73) Patentinhaber: Philipps-Universität Marburg, 35032 Marburg (DE)
(72) Erfinder: JÄNSCH, Heinz, Julius, 35037 Marburg (DE)
(74) Vertreter: Buchhold, Jürgen
(86) Internationale Anmeldenummer: PCT/DE2003/002767
(87) Internationale Veröffentlichungsnummer: WO 2004/019052

(56) Entgegenhaltungen:
- US-A- 6 051 208
- JÄNSCH H J ET AL: "A UHV compatible source for a highly polarized thermal atomic beam of radioactive /sup 8/Li" NUCLEAR INSTRUMENTS & METHODS IN PHYSICS RESEARCH, SECTION B (BEAM INTERACTIONS WITH MATERIALS AND ATOMS), DEC. 2000, ELSEVIER, NETHERLANDS, Bd. 171, Nr. 4, Seiten 537-550, XP004221512 ISSN: 0168-583X
- EARLE M.J., SEDDON K.R.: "Ionic liquids. Green solvents for the future" PURE AND APPLIED CHEMISTRY, Bd. 72, Nr. 7, 2000, Seiten 1391-1398, XP002266043

## Beschreibung

Die vorliegende Erfindung bezieht sich auf eine Vorrichtung und ein Verfahren zur Erzeugung einer kernspinpolarisierten Flüssigkeiten.

### [Stand der Technik]

Ausgehend vom Phänomen der kernmagnetischen Resonanz dient die Kern-Resonanz-Spektroskopie (NMR) und ihre besondere Ausprägung als Kern-Resonanz-Bildgebung (MRI) der Bestimmung lokaler Verteilungen der Kerndichte oder der Bestimmung von NMR-Charakteristika, welche sich auf die Kerne des Gegenstandes beziehen oder und durch physikalische oder chemische Einflüsse auf die Kerne des Gegenstandes entstehen.

Diese NMR-Charakteristika umfassen z.B.: Die Längsentspannung (als deren Maß die gleichnamige Zeit T1 dient), die Querentspannung (mit dem Maß der gleichnarnigen Zeit T2), die Entspannung in einem rotierenden Referenzrahmen (Maß: Entspannungszeit T1 rho), die chemische Verschiebung (chemical shift) und die Kopplungsfaktoren zwischen den Kernen.

Der Begriff "Kempolarisation" P bezeichnet den Anteil an orientierten Kernspins I (z.B. des Isotops 6Li) und der damit verbundenen magnetischen Kern-Dipolmomente µl entlang der Richtung eines äußeren Magnetfeldes B.

Es ist bekannt, dass die Kernresonanzspektroskopie (NMR) und die Bildgebung mittels Kernresonanz (MRI) große Bedeutung für die chemische Analytik, die Strukturaufklärung von Biomolekülen oder die medizinische Diagnostik hat.

Dabei wird in der MRI, welche zur Bildgebung dient, die lokale Verteilung von Kerndichte oder der NMR-Charakteristika eines Atoms/Ions untersucht. Für die Zwecke der chemischen Analytik, z.B. zur Bestimmung der Struktur von (Bio-) Molekülen wird dagegen häufig der Effekt der Spin-Austausch-Polarisierung, oder des Spinübergangs von in den Analyten eingebrachten Atomen/Ionen auf z.B. die 13-C-Atome des Analyten genutzt. Grundlage des Effekts ist hierbei die Spin-Spin-Wechselwirkung.

Zentrales Problem bei fast allen Anwendungen ist die geringe Empfindlichkeit der NMR/MRI Methoden. Diese Methoden nutzen im Wesentlichen die thermische Orientierung der Kernmagnele in einem äußeren starken Magnetfeld aus. Die erreichbare Kernpolarisation beträgt dabei lediglich 10^- 4 bis 10^-6 je nach verwendetem Nuklid, Magnetfeld oder Temperatur. In Ausnahmefällen sind zwar höhere Orientierungsgrade möglich (sehr tiefe Temperaturen, Nutzung der dynamischen Kernpolarisation, etc.), jedoch betrifft das in der Praxis eine verschwindend kleine Zahl von Anwendungsfällen. Im Regelfall muss geringe Empfindlichkeit mit hoher Messzeit (oftmalige Wiederholung der gleichen Messung und Addition der Ergebnisse) überwunden werden. Da sich das Signal-zu-Rauschverhältnis (S/N) nur mit der Wurzel der Wiederholungszahl bessern läßt, (4-malige Messung gibt 2-maliges S/N) sind der Verbesserung des Messsignals enge wirtschaftliche Grenzen gesetzt. So ist etwa die Messung der ortsaufgelösten Li-Verteilung im Hirn von Menschen (durch MRI) bisher nicht gelungen, obwohl Li-Salze die meistverordneten Mittel z.B. zur Unterdrückung der Zyklen bei manisch-depressiven Erkrankungen des Menschen sind. Mehr als 2 Mio. Amerikaner, grob 10 Mio. Patienten in der westlichen Welt leiden an dieser Krankheit.

Auch analytische Anwendungen, besonders bei Biomolekülen die nur in extrem kleinen Substanzmengen vorliegen, sind oft wegen der geringen Empfindlichkeit der NMRschwer oder gar nicht möglich Wenn etwa eine Messung einen Tag dauert, so ist die gleiche Messung bei 10 mal geringerer Substanzmenge faktisch unmöglich, da dazu 100 Tage Messdauer benötigt würden. Für kurze Zeiten (Sekunden bis Stunden bei Xe, He) lässt sich die Kernmagnetisierung im Einzelfall durch vielerlei Methoden (atomphysikalisch, kernphysikalisch, laseroptisch, chemisch, Transfer, Doppelresonanz, etc) erheblich steigern. Die Grenze des physikalisch Machbaren liegt bei einer Kernpolarisation von etwa 1, also 10^4 bis 10^6 mal höher als im thermischen Gleichgewicht. Die Messempfindlichkeit steigt dabei um diesen erheblichen Faktor.

Jedoch wurden diese Methoden meiste nur für die Kernspinpolarisierung von Gasen verwendet. Eine Ausnahme dazu bildet der Einsatz von flüssigem Xe (K.L.Sauer, R.J. Fitzgerald, W.Happer, Chem.Phys.Lett 277 (1997), p153-p158.) welches in gasförmiger Form unter Anwendung vonlaseroptischen Verfahren polarisiert und anschließend verflüssigt wird.

Zur Untersuchung biologischen Materials mittels NMR wurden in der Vergangenheit viele verschiedene Wege eingeschlagen.

Die US 5 833 948 schlägt :dazu kontraststeigernde Formulierungen für die NMR-Bildgebung von Blutströmungen vor. Die Formulierungen bestehen dabei aus liposomalen Mikrovesikeln, welche gekapselte paramagnetische Chelate als Träger von NMR Kontrastmitteln beinhalten. Als Kontrastmittel werden paramagnetische Metall-Ionen vorgeschlagen.

Im Hinblick auf ihre mögliche Anwendung in der Medizin werden darüber hinaus seit kurzer Zeit neben den üblichen Protonen (1-H) auch andere kernspinpolarisierte Isotope, wie 129-XE oder 3-HE untersucht. Zur Untersuchung der Ventilation der Lunge schlagen beispielsweise die DE 100 00 675 C2, sowie die WO 9 527 488 A1 und WO 9 737 239 A1 die Verwendung von diesen kernspinpolarisierten Isotopen in gasförmiger Form vor.

Das Herstellen von kernspinpolarisiertem 3He ist jedoch aufwändig. Ein weiterer genereller Nachteil von 3He liegt in der geringen Löslichkeit von 3He in wässrigen, polaren oder unpolaren Medien. Dadurch wird ein Einsatz von 3He etwa zur Untersuchung biologischer, aber auch von chemischen Proben, welche in der überwiegenden Mehrzahl in wäßriger oder anderen polaren oder unpolaren Lösungsmitteln vorliegen, z.B. durch Nutzung der "Spinaustauschpolarisierung" sehr ineffizient.

Andere bislang untersuchte Gase oder Edelgase. wie z.B. 129 Xe weisen nur leicht. bessere Löslichkeiten in wässrigen oder anderen polaren oder unpolaren Medien auf.

Dadurch sind diese hoch kernspinpolarisierbaren Gase nur begrenzt für die Bildgebung durch MRI (z.B. für die Untersuchung der Lunge) und nahezu gar nicht für die chemische Analytik, z.B. von Biomolekülen einsetzbar.

Bislang sind keine Möglichkeiten bekannt, hochkernspinpolarisierte Atome/Ionen mit ausreichender Ausbeute- in wässrige oder andere Lösungsmittel zu überführen, obwohl bekannt ist, dass eine ganz Reihe von Atom-/Ionen-Arten (etwa 1H. 2H, 3H, 3He, 6Li, 7Li, 23Na,..) in hochkernspinpolarisierter Form allerdings unter Hochvakuumbedingungen hergestellt werden können. So verwendet man in der Veröffentlichung von H. J. Jensch et al. "A UHV compatible source for a highly polarized thermal atomic beam of radioactive 8Li" (Nucl. Instr. and Meth. in Phys. Res. B 171 (2000), 537-550) eine Vorrichtung bestehend aus einer Vakuumapparatur mit Quellenkammer, (Nucl. Instr. and Meth. in Phys. Res. it 171 (2000), 537-550) Absorptionskammer und einer Vakuumpumpvorrichtung zur Erzeugung eines strahls aus lithium-Atomen einer Atomstrahl-Führungsvorrichtung bestehend aus mindestens einer Düse und Blende, einer Atom-Polarisationsvorrichtung zur Polarisation der Atome des Atomstrahls und einer Absorptionsvorrichtung. Hierbei kommen Separationsmagnete und optiches Pumpen mit zirkularpolarisiertem Licht zum Einsatz.

Grund für die Schwierigkeit, hochkernspinpolarisierte Atome/lonen mit ausreichender Ausbeute in wässrige oder andere Lösungsmittel zu überführen, ist der hohe Dampfdruck von wässrigen oder anderen polaren Lösungsmitteln bei Temperaturen oberhalb 0°C, so dass diese bislang nicht in Kontakt mit Atom/lonen-Quellen gebracht werden konnten, da die entsprechenden Atom-/lonenstrahlen nur unter Hochvakuum-Bedingungen führbar sind.

### [Aufgabe der Erfindung]

Aufgabe der Erfindung ist es, ein Verfahren und eine Vorrichtung anzugeben, unter deren Zuhilfenahme hoch kernspinpolarisierte Flüssigkeiten erzeugt werden können.

Besonders geeignet sind dazu kernspinpolarisierbare Flüssigkeiten, welche zudem über eine möglichst große Kernpolarisationserhaltungsfähigkeit (> 1 Sekunde), charakterisiert durch die sogenannte T1-Zeit (Längsentspannung), aufweisen.

Diese Aufgabe wird gelöst durch ein Verfahren gemäß Anspruch 14 und durch eine Vorrichtung gemäß Anspruch 1.

Nach dem erfindungsgemäßen Verfahren können hoch kernspinpolarisierte Flüssigkeiten dadurch hergestellt werden, dass Flüssigkeiten mit einer hohen Kernpolarisationserhaltungsfähigkeit, charakterisiert durch die sogenannte T1-Zeit, mit solchen Flüssigkeiten gemischt werden, welche einen geringen Dampfdruck von weniger als 0.1 Pa (10^-3 mbar) bei Raumtemperatur (20°C) aufweisen.

Erfindungsgemäß ist dabei die Flüssigkeit mit hoher Kernpolarisationserhaltung in Abstimmung mit der zu polarisierenden Atomart, in Hinblick auf eine hohe T1-Zeit, auszuwählen. Die Mischungsanteile der beiden Flüssigkeiten sind außerdem so zu wählen, dass der Dampfdruck an der Oberfläche des Gemisches eine Bestrahlung der zu polarisierenden Flüssigkeit mit hoch kernspinpolarisierten Atomen oder Ionen noch zuläßt.

Andererseits darf der Anteil der Flüssigkeit mit hoher Kernpolarisationserhaltungsfähgikeit (T1-Dauer) nicht zu gering sein, da sonst die Ausbeute pro Zeit oder die aus beiden Anteilen gemittelte T1-Dauer zu gering bzw. zu kurz ist.

In einem zweiten Schritt des erfindungsgemäßen Herstellverfahrens wird diese kernspinpolarisierbare Flüssigkeit dann - unter Ausbildung eines freien Flüssigkeitsfilms - in eine Vakuumapparatur überführt.

Im dritten Schritt des Verfahrens wird die polarsierbare Flüssigkeit im Bereich der freien Flüssigkeitsoberfläche mit hoch kernspinpolarisierten Atomen oder Ionen einmalig oder mehrmalig bestrahlt.

Danach wird die kernspinpolarisierte Flüssigkeit kontinuierlich oder periodisch aus der Vakuumapparatur herausgeführt.

Die kernspinpolarisierte Flüssigkeit steht dann unter Umgebungsbedingungen für die Zwecke der MRI oder NMR, z.B. als Lösungsmittel für Biomoleküle oder als injizierbares Kontrastmittel zur Verfügung.

Eine vorteilhafte Ausgestaltung des erfindungsgemäßen Herstellverfahrens ist dadurch gegeben, dass nach der Bestrahlung eine Anreicherung der hoch kerspinpolarisierten Anteile der Flüssigkeit durchgeführt wird. Für den Fall von H2O oder D2O als Komponente mit langer T1-Zeit kann dies z.B. durch Auswaschung dieses Anteils aus dem Gemisch mit dem Flüssigkeitsanteil geringer Dampfdichte realisiert werden.

Überraschenderweise konnten solchertei Flüssigkeiten z.B. in der Gruppe der sogenannten lonic Liquids gefunden werden.

Ein Beispiel für eine Flüssigkeit mit hoher Kernpolarisationserhaltungsfähigkeit für die Alkali-Atomarten, z.B. Li, ist H2O oder D2O oder Mischungen daraus.

H2O oder D2O als Anteil der zu polarisierenden Flüssigkeit bietet dem gelösten Lithium eine Umgebung, die im reinen Wasser zu sehr langen T1-Zeiten. für 6Li führt. So beträgt die T1-Zeit für 6Li in D2O 830 s bei 30°C und 1040 s bei 80°C.

Als Flüssigkeiten mit geringem Dampfdruck stehen grundsätzlich die seit langem bekannten Flüssigkeiten mit einem Dampfdruck von weniger als 0.1Pa (10^-3 mbar) bei Raumtemperatur (20°C) zur Verfügung, wie längerkettige Alkohole, Glykole, methylierte Glykole, wie etwa Diethylenglycol oder Diethyleriglycoldimethylester und Verwandte mit einem Dampfdruck von weniger als 1 Pa (10^-2 mbar)bei 20°C.

Vorteilhaft ist aber - aufgrund des bei Raumtemperaturen noch geringeren Dampfdrucks - der Einsatz von sogenannten ionischen Flüssigkeiten ("ionic liquids"). Darunter versteht man Salze, welche schon bei Zimmertemperatur (20°C) flüssig sind. Solche ionic liquids können z.B. seit 1999 von der Firma Solvent Innovation GmbH in Aachen bezogen werden.

Für die ionische Flüssigkeit BMIM-Tf2N ((1-Butyl-3-Methyl-Imidazol)-(Bis-trifluoromethylsulfonyl-amid)) mit Wasser (kleiner 1 mol-%) wurde z.B. eine Zeit von T1 gleich ca. 60 s bei 20°C ermittelt.

Vertreter der Gruppe der ionic liquids sind neben
a) BMIM-Tf2N = ((1-Butyl-3-Methyl-Imidazol)-(Bis-trifluoromethyl-sulfonyl-amid)), z.B. die Verbindungen
b) EMIM-BF4 = (1-ethyl-3-methyl-imidazol tetrafluoroborat) oder
c) BMIM-PF6 = (1-butyl-3-methyl-imidazol hexafluorophosphat).

Den Kern der Erfindung bildet die Erkenntnis, dass kernspinpolarisierbare Flüssigkeiten dadurch herstellbar sind, dass wässrige oder andere polare oder unpolare Lösungsmittel mit großen T1-Zeitdauern, z.B. für kernspin-polarisierbare Alkali-Atomarten, mit Flüssigkeiten mit sehr geringem Dampfdruck mischbar und in eine Vakuumapparatur überführbar sind, ohne dabei zu verdampfen.

Entscheidend für die polarisierbare Flüssigkeit ist, wie oben angedeutet, auch seine Kernpolarisationserhaltungsfähigkeit (T1-Zeit). Je länger diese ist, desto längere Beobachtungsdauern von z.B. biologischen Proben können mit verstärkter Kernspinpolarisation in der NMR oder MRI realisiert werden.

Kernspinpolarisierbare Flüssigkeiten, die Spuren von Wasser enthalten, etwa für 6Li oder 7Li, weisen besonders lange T1-Zeiten auf. Insbesondere die sogenannten Ionischen Flüssigkeiten können Wasser in kleinen definierten Mengen enthalten, da sie einerseits mit Wasser mischbar sind und andererseits auch wasserfrei hergestellt werden können.

Der Wasseranteil an der kernspin-polarsisierbaren Flüssigkeit muss so klein sein, dass der Druck der Mischung nicht über etwa 0.1 Pa (10^-3 mbar) liegt. Dies wird erreicht wenn die Wasserkonzentration in z.B. BMIM-Tf2N unter 1 mmotar liegt, bei einer Temperatur von unter 35 °C.

Aufgabe der vorliegenden Erfindung ist es auch, eine Vorrichtung anzugeben, mit deren Einsatz die erfindungsgemäße kernspinpolarisierte Flüssigkeit herstellbar ist.

### [Beispiele]

Das erfindungsgemäße Verfahren und die erfindungsgemäße Vorrichtung zur Herstellung einer hoch kernspinpolarisierten Flüssigkeit soll am Beispiel von Lithium und hier speziell dem Isotop 6Li beschrieben werden.

Durchführbar ist das Verfahren für weitere Alkaliatomsorten etwa Natrium oder Kalium sowie weitere Atomsorten etwa Fluor, Chlor oder Wasserstoff.

Generell können alle Atomsorten, für welche Verfahren zur Erzeugung von Kernspinpolarisation existieren, in der erfindungsgemäßen Vorrichtung und nach dem erfindungsgemäßen Verfahren zur Herstellung von kernspinpolarisierten Flüssigkeiten eingesetzt werden.

Nach Wahl der Atomart (hier Li) und einer dazu passenden Flüssigkeit mit hoher Kernspinpolarisationserhaltung (T1. hier H2O oder D2O) wird eine damit mischbare Flüssigkeit gewählt (hier z.B. BMIM-Tf2N). Die Anteile und die Temperatur der beiden Flüssigkeiten werden dann, in Abstimmung mit der Art der gewählten Flüssigkeit mit hoher T1-Dauer, so gewählt, dass bei Normallemperatur von 20°C der Dampfdruck der Mischung der beiden Flüssigkeiten 1 Pa (10^-2 mbar) nicht übersteigt.

Die zu polarisierende Flüssigkeit wird dann in eine Vakuumapparatur überführt. Im Vakuum wird aus einem heizbaren Gefäß (etwa Edelstahlbehältnis mit Düsenöffnung) 6Li erhitzt und dadurch verdampft. Aus dem Dampf vor der Düse wird ein Strahl mittels Blenden herausgeschält, Dieser Atomstrahl durchfliegt einen Magneten mit inhomogenem Magnetfeld, der als Dipolmagnet, Quadrupol- oder Sextupolmagnet gearbeitet sein kann. Wegen der besseren Strahlführungseigenschaften sind Quadrupol- oder Sextupolmagnete vorzuziehen. Besonders geeignet sind Magneten mit konisch geformten Magnetprofilen.

Die auf den Spin der Atome wirkenden Kräfte zerteilen den Atomstrahl in zwei Anteile, den mit Elektronenspin parallel zum äußeren Feld (Komponente 'Spin-Up') und den Anteil mit zum äußeren Feld antiparallelem Spin (Komponente 'Spin-Down'). Die unterschiedlichen Kräfte auf beide Komponenten bewirken eine räumliche Separation, so dass beispielsweise die Spin-Down Komponente ausgeblendet wird, also nur noch die Spin-Up Komponente weiterfliegt.

Alternativ zur Polarisationsvorrichtung in Form des Separationsmagneten kann auch eine Präparationsvorrichtung welche nach dem Prinzip des 'Optischen Pumpens' arbeitet eingesetzt werden, um die Spin-Up (oder die Spin-Down) Komponente zu präparieren.

Die Wellenlänge des "Pumplichls" ist dabei auf die Absorptionslinien der verwendeten, zu polarisierenden Atome/Ionen aus der Gruppe Alkaliatome etwa Natrium oder Kalium, Fluor, Chlor oder Wasserstoff abzustimmen. Für das Element Li ist "Pumplicht" der Wellenlänge 670.8 nm zu wählen.

Auch eine Kombination beider Verfahren kann sinnvoll sein.

Bei der Präparation mittels "optischem Pumpen" kann die Kernpolarisation schon einen gewünschten sehr hohen Wert annehmen (leicht über 80% vom Maximalwert). Bei Benutzung der Separationsmagneten liegt die Kernpolarisation im Falle von 6Li zwischen 0% und 33% des Maximalwerts, je nach dem in welchem Magnetfeld sich die Atome befinden. Nutzt man einen Hochfrequenzübergang zusätzlich zum Separationsmagneten, so kann die Kernpolarisation auf 66% gesteigert werden.

Der so präparierte Atomstrahl - durch Separationsmagneten oder optisches Pumpen alleine oder durch die Kombination der beiden Präparationsverfahren - kann nun direkt in Lösung gebracht werden oder die Atome können an einem heißen Oberflächenionisator in einen Ionenstrahl verwandelt werden, so dass Ionen statt Atome über eine freie Flüssigkeitsoberfläche in die zu polarisierende Flüssigkeit überführt werden können.

Der Druck im Bereich der Überführung der Atom-/Ionenstrahlen in die zu polarisierende Flüssigkeit sollte kleiner als 0.1 Pa (10-3 mbar) bleiben, um den ungehinderten Transport des Atomstrahls zur freien Oberfläche der polarisierbaren Flüssigkeit zu gewährleisten. Der Druck stellt sich durch den Dampfdruck der zu polarisierenden Flüssigkeit und die an der Apparatur angebrachten Pumpen ein, so dass etwas höherer Dampfdruck durch ein mehr an Pumpen kompensiert werden kann. Dies kann etwa durch mit flüssigem Stickstoff gekühlte Bleche erzeugt werden, die als Kryopumpe wirken und geometrisch sehr nahe an die polarisierbare Flüssigkeit herangebracht werden können. Zur Vorkühlung. vor Eintritt in die Vakuumkammer, kann die zu polarisierende Flüssigkeit z.B. durch äußere Beaufschlagung der Zuführungsleitungen mit einer - koaxial die Leitungen umfassend geführten - flüssigen Stickstoff- oder kalten Gas-Strömung gekühlt werden. Im Bereich der freien Flüssigkeitsoberfläche ist so der Dampfdruck absenkbar.

Eine weitere Absenkung des Dampfdrucks im Bereich der freien Flüssigkeitsoberfläche ist dadurch erzielbar, dass die Rückseite, d.h. die der Atom-/Ionenstrahlung abgewandte Seite der freien Flüssigkeitsoberfläche über einen z.B. durch flüssigen Stickstoff gekühlten Kühlkörper in flüssiger Form geführt wird.

Im Fall der Herstellung von polarisierten Atomstrahlen ist der räumliche Bereich, in welchem der Atomstrahl in Lösung gebracht wird, einem in der Richtung und Stärke so konstanten Magnetfeld auszusetzen, dass die "Bedingung" nicht verletzt wird. Zur Adiabatizitäts-Bedingung siehe auch W. Haeberli, Ann. Rev. Nucl. Sci. 17, (1961), 313. Ein Magnetfeld von ca. 3x10⁻²T (300 Gauss) (für 6 Li z.B.), welches durch einen Permanent-Magneten oder Spulen erzeugt werden kann, ist dazu auch für den Fall, dass sich die Vorrichtung in magnetischen Störfeldern befindet, im Allgemeinen ausreichend. Für den Fall, dass keine oder nur geringe Störfelder im Bereich der Vorrichtung vorhanden sind, reichen auch Magnetfeldstärken von 10⁻⁴T (1 Gauss)

Im Fall der Herstellung von polarisierten Ionenstrahlen muss sich die Ionisationsvorrichtung in einem Magnetfeld befinden, welches die Adiabatizitäts-Bedingung" (s. oben) nicht verletzt. Die nachfolgend mit den so erzeugten Ionen zu bestrahlende freie Flüssigkeitsoberfläche muss sich dann nicht in einem der Adiabatizitäts-Bedingung genügenden Magnetfeld befinden.

Die in diesem Beispiel mit Alkali-Atomen/-Ionen (hier 6Li) zu beladene - und damit zu polarisierende - Flüssigkeit kann nach der Bestrahlung dann in einem kontinuierlichen oder diskontinuierlichen Verfahren aus dem Vakuum herausgepumpt oder unter dem Einfluss der Schwerkraft herausgelassen werden, so dass sie unter Normaldruckbedingungen weiterverarbeitet werden kann.

Für spezielle Verwendungsfälle kann die hoch kernspinpolarisierte Flüssigkeit direkt in NMR oder MRI Messungen verwendet werden.

Eine wässrige Lösung der Alkaliatome erhält man durch Auswaschen der hier verwendeten Alkaliatome-/lonen mit oder ohne den Anteil der Flüssigkeit mit hoher T1-Dauer aus dem Anteil der Flüssigkeit mit geringem Dampfdruck.

Die nachfolgenden Beispiele verdeutlichen verschiedene Ausführungsbeispiele der erfindungsgemäßen Vorrichtung und des erfindungsgemäßen Verfahrens zur- Herstellung von kernspinpolarisierten Flüssigkeiten ohne Anspruch auf Vollständigkeit.
Fig. 1 zeigt dazu den Aufbau der Herstellvarrichtung umfassend eine Vakuumapparatur mit den beiden Teilkammern Quellenkammer (1) und Absorptionskammer (2) und umfassend eine optische Polarisationsvorrichtung mit einem optischen Resonator, gebildet aus Resonator-Spiegelelementen (B.2).
Fig. 2 zeigt eine alternative Herstellvorrichtung mit einer optischen Polarisationsvorrichtung umfassend gewöhnliche Spiegelelemente (B.3), welche keinen optischen Resonator ausbilden.
Fig.3 zeigt eine dritte Ausführungsvariante der Herstellvorrichtung mit einer Polarisationsvorrichtung (B) in Form von Separationsmagneten (B.10, B.10').
Fig. 4 zeigt eine vorteilhafte Absorptionsvorrichtung (C) mit einem Flüssigkeitsmitnehmer (C.6) in Form einer motorisch antreibbaren Drehscheibe als Flüssigkeitsmitnehmer (C.6) und einem Abstreifer (C.8), an welcher die polarisierte Flüssigkeit zu einer Rückleitung (C.1) geführt wird.
Fig. 5 zeigt eine weitere vorteilhafte Ausgestaltung der erfindungsgemäßen Herstellvorrichtung.
   Darin werden die aus der Quellenkammer (1) austretenden Atome vor Erreichen der Absorptionsvorrichtung ionisiert.
Fig.6 zeigt eine weitere vorteilhafte Ausgestaltung der erfindungsgemäßen Herstellvorrichtung mit einer Polarisationsvorrichtung (B) in Form von Separationsmagneten (B.10, B.10') und einer Vorrichtung zur Erzeugung eines Hochfrequenzübergangs (H.1, H.2) mit einer Spule (H.1) und Magneten (H.2), welche ein inhomogenes Magnetfeld erzeugen.

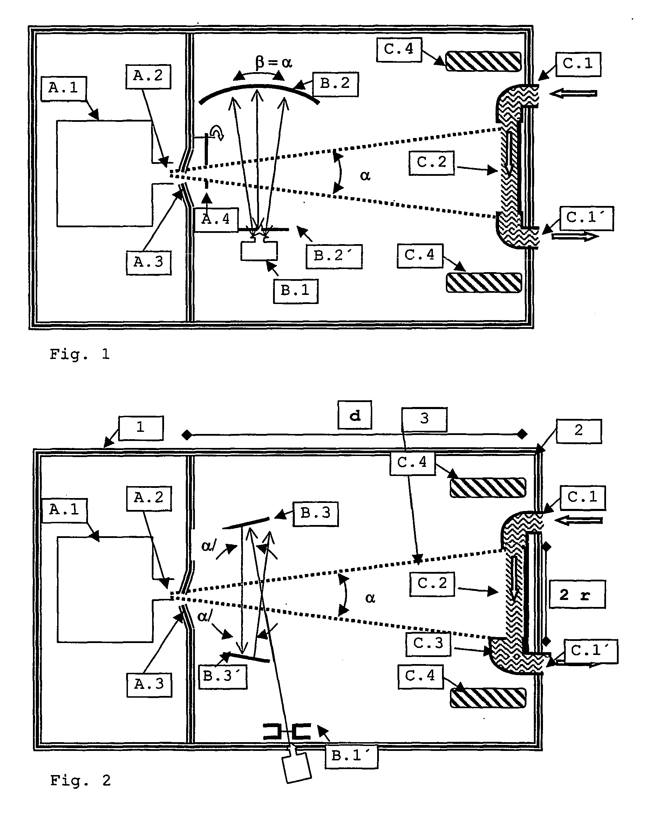

Fig.1 zeigt die Quellenkammer (1) mit einer Verdampfungsvorrichtung (A), welche einen Austritt zur Abgabe der erzeugten Atome oder Ionen aufweist. Die Atome oder Ionen werden dann durch Blenden (A.3, A.3') zu einem Strahl geformt, welcher in einer verbesserten Ausführungsform zur weiteren Strahlformung durch eine oder mehrere revoltierende Lochblenden (A.4) geleitet wird, treten weiter in die Absorptionskammer (2) ein, passieren die Polarisations-Vorrichtung (B) und erreichen die Absorptionsvorrichtung (C).

Die Kernspin-Polarisation geschieht in diesem Fall durch sogenanntes "optisches Pumpen". In der Polarisations-Vorrichtung (B) wird dazu als Lichtquelle (B.1) z.B. eine schmalbandige Laser-Diode eingesetzt, welche in dem zur Atomart Li passenden Absorptionsbereich Licht der Wellenlänge 670 nm emittiert. Die Lichtquelle sendet dazu polarisiertes oder unpolarisiertes Licht einer Frequenzkomponente oder mehrerer Komponenten aus. Die Lichtquelle kann dazu auch außerhalb der Vakuumkammer angebracht sein (siehe dazu Fig.2). Die Resonator-Spiegelelemente B.2 und B.2' bilden einen Resonator zur Erhöhung der Lichtintensität.

Der Radius r.B.2 des gekrümmten Resonator-Spiegelelementes (B.2) - und in einer nicht dargestellten Ausführungsform, auch der Radius r.B.2' des Resonator-Spiegelelementes B.2' - ist dabei auf den Aufweitungswinkel α des Atom-/lonenstrahls abgestimmt. Der abgedeckte Winkelbereich β entspricht dem Aufweitungswinkel α des Atom/lonenstrahles.

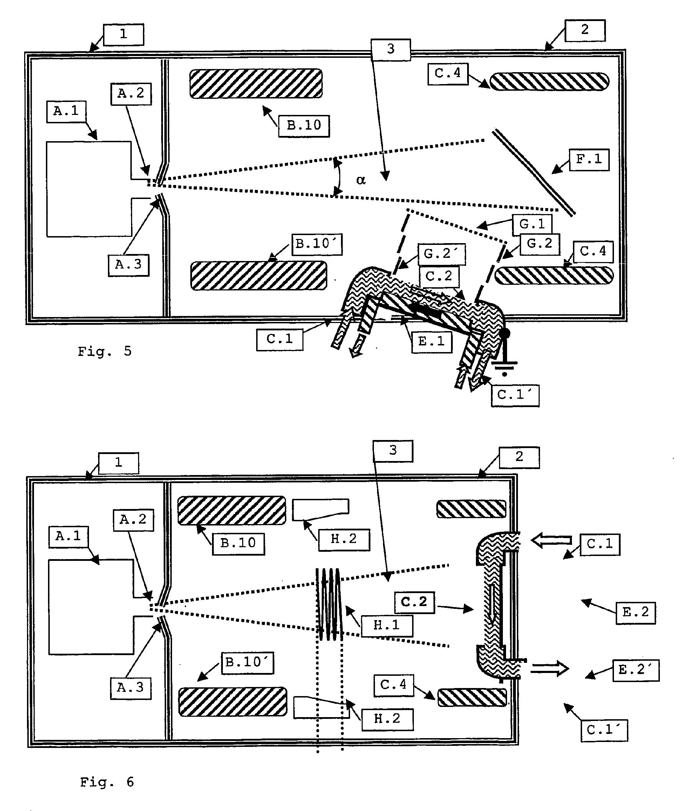

Nach der Polarisations-Vorrichtung und im Falle der Erzeugung von Ionen nach der lonisationsvorrichtung (siehe Fig. 5), erreicht der Atom-/lonenstrahl die Absorptionsvorrichtung (C), welche eine freie Flüssigkeitsoberfläche (C.1) aufweist.

Die Atome/lonen werden an dieser freien Flüssigkeitsoberfläche oder im darunter befindlichen Flüssigkeitsfilm absorbiert. Im Falle der Herstellung von Atomstrahlen befindet sich sowohl die Flüssigkeitsoberfläche als auch der darunter liegende Film vorteilhafterweise innerhalb eines durch Magnetfeldquellen (C.4' und C.4"), z.B. durch die hier gewählten Permanentmagneten gebildeten Magnetfeldes. Das Magnetfeld muss dabei die Adiabatizitäts Bedingung erfüllen.

Im Falle der Herstellung von Ionen ist es vorteilhaft, wenn sich lediglich der lonisator innerhalb eines die Adiabatizitäts- Bedingung erfüllenden Magnetfeldes befindet (s. Fig. 5).

Im vorliegenden Beispiel wird die zu polarisierende Flüssigkeit permanent umgewälzt unter Bildung eines frei fallenden Flüssigkeitsfilms, welcher zumindest teilweise den Bereich des Atom-/Ionenstrahls kreuzt.

Fig.2 zeigt eine alternative Herstellvorrichtung mit einer Polarisationsvorrichtung, welche als Lichtquelle (B.1) etwa eine Laserdiode wie in Fig. 1 und mehrere gewöhnliche Spiegelelemente (B.3', B.3") vorsieht.

Der Winkel unter welchem die Lichtquelle im Verhältnis zum Atom-/Ionenstrahlkegel einstrahlt, ist im Zusammenhang mit der Ausrichtung der Spiegelelemente (B.3', B.3") so zu wählen, dass eine Frequenzverschiebung durch den Dopplereffekt während der Lichtabsorption für möglichst alle Atome im Strahl-Konus a minimiert wird. Im Gegensatz zu Fig. 1 ist die Lichtquelle (8.1) hier außerhalb der Vakuumapparatur angebracht und die Strahlung wird durch einen optischen Durchgang (B.11) in die Vakuumkammer übertragen.

Im Gegensatz zu Fig.1 ist hier keine kontinuierliche Umwälzung der zu polarisierenden Flüssigkeit vorgesehen, da die Absorptionsvorrichtung ein größeres Auffangbecken (C.3) aufweist.

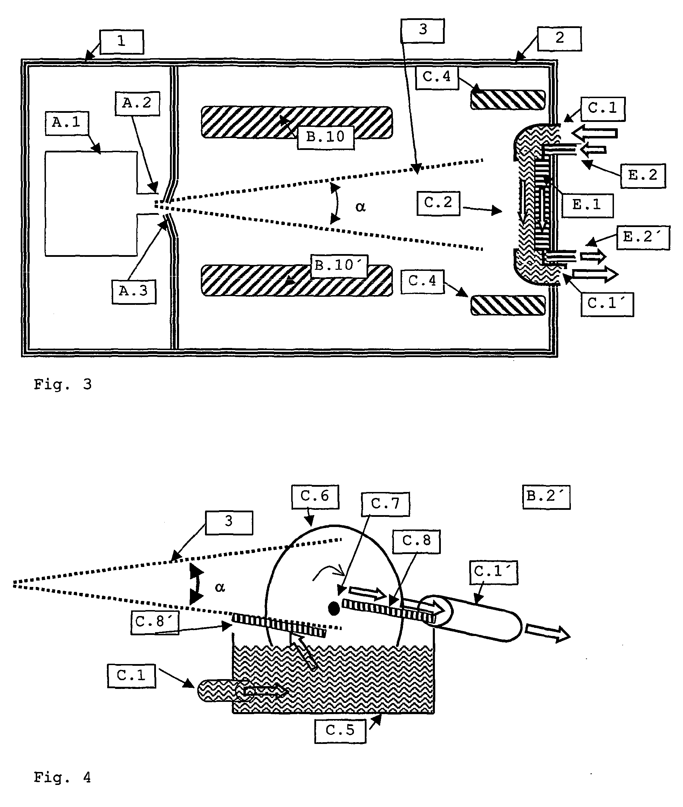

Fig. 3 zeigt eine dritte Ausführungsvariante der Herstellvorrichtung bei dem die Präparation des Atom/lonenstrahls durch Separationsmagneten geschieht. Der Atomstrahl durchfliegt ein von Separationsmagneten gebildetes inhomogenes Magnetfeld, wobei die Magnete als Dipolmagnet. Quadrupol- oder Sextupolmagnet gearbeitet sein können. Wegen der besseren Strahlführungseigenschaften sind Quadrupol- oder Sextupolmagnete vorzuziehen. Besonders geeignet sind Magneten mit konisch geformten oder/und abgerundeten Magnetprofilen.

Fig.4 zeigt eine vorteilhafte Absorptionsvorrichtung (C) mit einer Zuteilung (C.1) einem Vorratsreservoir (C.5), einem Flüssigkeitsmitnehmer (C.6) in Form einer motorisch antreibbaren Drehscheibe und einem Abstreifer (C.8) an welcher die polarisierte Flüssigkeit zu einer Rückleitung (C.1') geführt wird. Vorteilhaft ist hier die Anbringung eines zweiten Abstreifers (C.8') welcher in Drehrichtung des Mitnehmers (C.6) vor dem Abstreifer (C.8) gelegen ist. Dadurch läßt sich die Filmdicke des mitgenommenen Flüssigkeitsfilms reduzieren.

Mittels einer Regelvorrichtung, umfassend eine Kernspinpolarisationsmessvorrichtung, eine Ist-/Sollwertvergleichsvorrichtung und eine Motor-Drehzahlsteuerung für den Flüssigkeitsmitnehmer sowie einer Steuerung für die Temperatur der Atom/lonenstrahlquelle kann die Kernspinpolarisation geregelt werden.

Fig. 5 zeigt eine weitere vorteilhafte Ausgestaltung der erfindungsgemäßen Herstellvorrichtung. Darin werden die aus der Quellenkammer (1) austretenden Atome vor Erreichen der Absorptionsvorrichtung ionisiert. Zur Ionisation wird hier eine konventionelle Ionisationsvorrichtung (F), etwa ein Oberflächenionisator. z.B. ein oder mehrere Wolfram-Bleche oder ein mit Sauerstoff belegtes Wolfram-Blech oder ein Blech eines anderen Materials, welches Schmelztemperaturen oberhalb von ca. 1.500°C und eine für das gewählte Material spezifische genügend hohe Austrittsarbeit aufweist, genutzt.

Die Ionen werden dann mittels Hochspannung auf eine geeignete kinetische Energie beschleunigt, so dass sie in die Oberfläche des freien Films, der polarisierbaren Flüssigkeit eindringen können. Die Absorptionstiefe liegt bei 20-50keV bei ca. 1 µm.

Vorteilhaft für die weitere Nutzung der Flüssigkeit ist es dabei, die Flüssigkeit auf Erdpotential zu legen und die Ionisationsvorrichtung demgegenüber auf ein positives Potential zu legen.

Weiterhin vorteilhaft ist es, zur Führung der Ionen zwischen lonisator und der zu polarisierenden Flüssigkeit eine elektrostatische Transportvorrichtung (G) mit elektrostatischen Netzen (G.1) und Linsen (G.2. G.2'. G2", G2"') vorzusehen.

Fig.6 zeigt eine weitere vorteilhafte Ausgestaltung der erfindungsgemäßen Herstellvorrichtung mit einer Polarisationsvorrichtung (B) in Form von Separationsmagneten (B.10, B.10') und einer Vorrichtung zur Erzeugung eines Hochfrequenzübergangs (H) mit einer Spule (H.1) und Magneten (H.2, H.2'), welche ein inhomogenes Magnetfeld erzeugen.

Anstelle des Magneten können auch Spulen und ein entsprechend geformtes Eisenjoch zur Erzeugung eines inhomogenen Feldes eingesetzt werden.

Bei Auswahl einer polarisierbaren Flüssigkeit mit einem sehr geringen Anteil an Flüssigkeit mit geringem Dampfdruck ist es - zur Reduktion des Vakuumpumpaufwands - vorteilhaft, wenn der freie Flüssigkeitsfilm, im Falle der Nutzung von Ionenstrahlung, durch eine Folie vom Rest der Absorptionskammer getrennt wird.

Die Beschleunigungsspannung und die Foliendicke müssen aufeinander abgestimmt sein, so dass die Ionen nicht in der Folie stecken bleiben. Simulationen haben dazu gezeigt, dass z.B. eine Polypropylenfolie von 100 nm Dicke von einem 6Li Strahl, der 30 keV kinetische Energie aufweist, durchschossen werden kann. Die ins Wasser eingebrachten Ionen werden abgebremst und befinden sich in der gewünschten Umgebung, z.B. in einer Umgebung mit hohem D2O-Anteil und damit hoher Kernpolarisationserhaltungsfähigkeit. Die mechanische Stabilität der Folie kann durch hochtransparente aber feinmaschige Gitter erheblich gesteigert werden, so dass die Folien dem Dampfdruck der zu polarisierenden Flüssigkeit und bei geeigneter Auslegung sogar Atmosphärendruck gegenüber dem ionenstrahlseitigen Vakuum ausgesetzt werden können.

### [Bezugszeichenliste]

- Quellenkammer: (1)
- Absorptionskammer: (2)
- Kreuzungsbereich: (2.X)
- Partikelstrahl: (3)

- Verdampfungsvorrichtung: (A)
- Partikelquelle: (A.1)
- Düse: (A.2)
- Blenden: (A.3)
- Revolver mit Lochblenden: (A.4)

- Polarisationsvorrichtung: (B)
- Lichtquelle: (B.1)
- Resonator-Spiegelelement: (B.2)
- Spiegelelemente: (B.3)
- Radius Spiegelelement: (r.B.2)
- Separationsmagneten: (B.10)
- Optischer Durchgang für Lichtquelle: (B.11)

- Absorptionsvorrichtung: (C)
- Zu-/Abfuhrleitungen: (C.1)
- Freie Flüssigkeitsoberfläche: (C.2)
- Auffangbecken: (C.3)
- Magnetfeldquelle: (C.4)
- Vorratsbehälter: (C.5)
- Flüssigkeitsmitnehmer: (C.6)
- Drehachse: (C.7)
- Flüssigkeitsabstreifer: (C.8)
- Folie: (C.9)

- Vakuumpumpvorrichtung: (D)
- Vorpumpe: (D.1)
- Hochvakuumpumpe: (D.2)
- Vakuumventil: (D.3)

- Kühlvorrichtung: (E)
- Kühlkörper: (E.1)
- Kühlmittelzu-/Abfuhr: (E.2)

- Ionisationsvorrichtung: (F)
- Ionisationsblech: (F.1)

- Elektrostatische Transportvorrichtung: (G)
- Elektrostatisches Netz: (G.1)
- Elektrostatische Linse: (G.2)

- Hochfrequenzübergangs-Vorrichtung: (H)
- Spule: (H.1)
- Magneten: (H.2)

## Patentansprüche

1. Vorrichtung zur Erzeugung einer kernspinpolarisierten Flüssigkeit, bestehend aus
- einer Vakuumapparatur, enthaltend eine Quellenkammer (1) und eine Absorptionskammer (2)
- einer Vakuumpumpvorrichtung (D),
- einer in der Quellenkammer untergebrachten Quelle (A.1), welche Atome zur Erzeugung eines Atomstrahls bereitstellt,
- einer Atomstrahl-Führungsvorrichtung bestehend aus mindestens einer Düse und einer Blende (A2,A3),
- einer Polarisationsvorrichtung (B) zur Kernspin-Polarisation der Atome des Atomstrahls, und eventuell einer lonisationsvorrichtung zur Ionisierung der polarisierten Atome,
- einer Absorptionsvorrichtung (C) mit Zu- und Ableitungen (C.1, C.1'), die dazu dienen, die zu polarisierende Flüssigkeit in die Absorptionskammer hinein- und nach Polarisierung durch Bestrahlung mit den kernspinpolarisierten Atomen bzw. Ionen wieder hinauszuführen,
wobei die Absorptionsvorrichtung entweder so ausgestaltet ist, dass eine von der Zu- zur Ableitung fliessende Flüssigkeit in einem Kreuzungsbereich (2.X) mit dem Strahl aus Atomen bzw. Ionen dem Strahl unabgeschirmt ausgesetzt ist, oder - im Falle der Bestrahlung mit Ionen - in einem Kreuzungsbereich (2.X) mit dem Ionenstrahl durch eine von den Ionen zu durchdringende Folie vom Rest der Absorptionskammer getrennt ist, wobei die durch die Absorptionskammer geleitete Flüssigkeit hinter der Folie einen Flüssigkeitsfilm ausbildet.

2. Vorrichtung nach Anspruch 1, worin als Polarisationsvorrichtung (B) eine Vorrichtung nach dem Funktionsprinzip des optischen Pumpens vorgesehen ist, mit einer auf die Absorptionslinien des zu polarisierenden Atoms abgestimmten Lichtquelle.

3. Vorrichtung nach Anspruch 2, wobei die Vorrichtung nach dem Funktionsprinzip des optischen Pumpens einen optischen Resonator, gebildet durch mindesten zwei Resonator-Spiegelelemente (B.2, B.2') aufweist, wobei einer oder beide Krümmungsradien der Resonator-Spiegelelemente so auf den Aufweitungswinkel α des Atomstrahls abgestimmt ausgebildet sind, dass eine Frequenzverschiebung durch den Dopplereffekt während der Lichtabsorption für möglichst alle Atome im Strahl-Konus α minimiert wird.

4. Vorrichtung nach Anspruch 2, wobei die Vorrichtung nach dem Funktionsprinzip des optischen Pumpens mehrere gewöhnliche Spiegelelemente (B.3', B.3") aufweist, wobei der Winkel unter welchem die Lichtquelle im Verhältnis zum Atomstrahlkegel einstrahlt, im Zusammenhang mit der Ausrichtung der Spiegelelemente (B.3', B.3") so gewählt ist, dass eine Frequenzverschiebung durch den Dopplereffekt während der Lichtabsorption für möglichst alle Atome im Strahl-Konus a minimiert wird.

5. Vorrichtung nach Anspruch 1, worin als Polarisationsvorrichtung (B) Separationsmagnete (B.10, B.10') oder Separationsmagnete und eine Hochfrequenzübergangs-Vorrichtung (H) vorgesehen sind, beispielsweise mit einer Spule (H.1) im Bereich des inhomogenen Magnetfelds der Magneten (H.2, H.2').

6. Vorrichtung nach einem der Ansprüche 1 bis 5, wobei die Absorptionsvorrichtung (C) zwischen den Zu- und Abführleitungen. (C.1, C.1') mindestens einen Vorratsbehälter (C.5) aufweist.

7. Vorrichtung nach einem der Ansprüche 1 bis 6, eingerichtet zur aktiven Umwälzung der Flüssigkeit.

8. Vorrichtung nach einem des Ansprüche 1 bis 7, wobei die Absorptionsvorrichtung (C) zumindest in dem Bereich, in dem die Flüssigkeit dem atom-bzw. Ionenstrahl ausgesetzt ist, eine Kühlvorrichtung (E), z.B. als Kühlblech an der der kernspinpolarisierten Strahlung abgewandten Seite angebracht aufweist, wobei als Kühlung die Strömung von flüssigem Stickstoff oder kaltem Gas vorgesehen ist.

9. Vorrichtung nach einem der Ansprüche 6, 7 oder 8, sofern von Anspruch 6 abhängig wobei die Absorptionsvorrichtung (C) einem in dem Vorratsbehälter (C.5) eintauchenden, um eine Drehachse (C.7) drehbaren Flüssigkeitsmitnehmer (C.6) zur Ausbildung eines Filmes und einen daran angebrachten Flüssigkeitsabstreifer (C.8) aufweist welcher den so gebildeten polarisierten Flüssigkeitsfilm aufnimmt und zur Ableitung führt.

10. Vorrichtung nach einem die Ansprüche 1 bis 9 wobei sie Magnetfeldquellen (C.4) aufweist, die ein Magnetfeld in krenzungsbereich (2.X) erzeugen

11. Vorrichtung nach Anspruch 10, wobei in Strahlrichtung zwischen Polarisationsvorrichtung (B) und Absorptionsvorrichtung (C) eine Ionisationsvorrichtung (F), z.B. bestehend aus Ionisationsblechen (F.1. F.1') angeordnet ist, so dass in der Flüssigkeit (C.2) polarisierte Ionen absorbiert werden, wobei die Ionisationsbleche innerhalb des Magnetfeides der Magnetfeldquelle (C.4) angeordnet sind.

12. Vorrichtung nach Anspruch 11, wobei in Strahlrichtung zwischen lonisationsvorrichtung (F) und Absorptionsvorrichlung (C) eine elektrostatische Transportvorrichtung (G), z.B. bestehend aus einem elektrostatischen Netz (G.1) und mindestens einer elektrostatischen Linse (G.2) vorgesehen ist, zur Führung der Ionen zur Flüssigkeit (C.2) der Absorptionsvorrichtung (C)

13. Vorrichtung nach einem der Ansprüche 1 bis 12, wobei in Strahlrichtung nach der Düse und ersten Blende (A.2, A.3) mindestens eine weitere Blende in Form eines Revolvers mit Lochblenden (A.4) angeordnet ist.

14. Verfahren zur Erzeugung einer kernspinpolarisierten Flüssigkeit mittels einer Vorrichtung nach einem der Ansprüche 1 bis 13, umfassend folgende Schritte:
a) Bereitstellung einer Atomsorte zur Erzeugung des Atomstrahls, und Auswahl einer ersten Flüssigkeit, in der die T1-Zeit für die kernspinpolarisierten Atome des Atomstrahls mehr als 1 Sekunde beträgt,
b) Mischung eines Anteils der ersten Flüssigkeit mit einer Flüssigkeit mit geringem Dampfdruck, so dass der Dampfdruck der Flüssigkeitsmischung 1 Pa (10⁻² mbar) bei einer Temperatur von 20 °C des Gemisches nicht übersteigt;
c) Überführung der Flüssigkeitsmischung in die Vorrichtung nach einem der Ansprüche 1 bis 13, wobei die Flüssigkeitsmischung über die Zuleitung in die Absorptionskammer geleitet wird;
d) Bestrahlung der Flüssigkeitsmischung mit dem kernspinpolarisierten Atom- bzw. Ionenstrahl, wobei sich im Falle der Bestrahlung mit Ionen die Ionisationsvorrichtung und im Falle der Bestrahlung mit Atomen die dem Atomstrahl ausgesetzte Flüssigkeitsoberfläche innerhalb eines Magnetfeldes befindet, wobei für die durch das Magnetfeld fliegenden kernspinpolarisierten Atome bzw. Ionen die Adiabatizitätsbedingung erfüllt ist;
e) Abführung der bestrahlten und damit polarisierten Flüssigkeitsmischung aus der Vorrichtung.

15. Verfahren nach Anspruch 14, worin die polarisicrbare Flüssigkeit einen Anteil H2O oder/und D2O aufweist.

16. Verfahren nach Anspruch 14 oder 15, worin die polarisierbare Flüssigkeit einen Anteil eines Ionic Liquids. insbesondere aus der Gruppe:
a) BMIM-Tf2N = ((1-Butyl-3-Methyl-Imidazol)-(Bis-trifluoromethyl-sulfonyl-amid)),
b) EMIM-BF4 = (1-ethyl-3-methyl-imidazol tetrafluoroborat) oder
c) BMIM-PF6 = (1-butyl-3-methyl-imidazol hexafluorophosphat) aufweist.

17. Verfahren nach einem der Ansprüche 14 bis 16, wobei die polarisierbare Flüssigkeit portionsweise oder kontinuierlich zu oder/und abgeführt wird.

18. Verfahren nach einem der Ansprüche 14 bis 17 wobei im Falle der Herstellung von Ionen in der Vakuumapparatur eine Beschleunigungsspannung zwischen der lonisationsvorrichtung (F) und der Absorptionsvorrichtung (C) angelegt wird.

19. Verfahren nach einem der Ansprüch 14 bis 18. wobei die zu polarisierende oder/und polarisierte Flüssigkeit innerhalb der Absorptionsvorrichtung (C) zur Reduktion des Dampfdrucks gekühlt wird.

20. Verfahren nach einem der Ansprüche 14 bis 19 wobei der polarisierte Anteil der Flüssigkeit nach der ersten und/oder jeder weiteren Bestrahlung angereichert wird.

21. Verfahren nach Anspruch 20, wobei die Anreicherung durch Auswaschung oder andere chemische Trennverfahren erfolgt.

## Claims

1. Device for producing liquids having a nuclear spin polarization comprising
- a vacuum apparatus containing a source chamber (1) and an absorption chamber (2),
- a vacuum pumping device (D),
- a source (A.1) located within the source chamber which provides atoms for the creation of an atomic beam,
- a guiding device for the atomic beam comprising at least one nozzle and one aperture (A.2, A.3),
- a polarization device (B) for the nuclear spin polarization of the atoms of the atomic beam and optionally an ionization device for ionizing of the polarized atoms,
- an absorption device (C) comprising feed lines and draining lines (C.1, C.1') which serve to lead the liquid to be polarized into the absorption chamber and out again, after polarizing said liquid by irradiating it with the nuclear spin polarized atoms or ions,
wherein the absorption device is either formed in such a way that a liquid flowing from the feed lines to the draining lines is exposed in an unshielded manner in an intersection (2.X) with the beam formed by atoms or ions to said beam, or - in the case of irradiating with ions - said liquid is separated in an intersection (2.X) with the ionic beam from the rest of the absorption chamber by a foil suitable to be permeated by said ions, wherein the liquid directed through the absorption chamber forms a liquid film behind said foil.

2. Device according to claim 1, wherein the polarization device (B) is a device according to the functioning principle of optical pumping and is equipped with a light source adjusted to the absorption lines of the atom to be polarized.

3. Device according to claim 2, wherein the device according to the functioning principle of optical pumping comprises an optical resonator, formed by at least two resonator mirror elements (B.2, B.2') wherein one or both radius(es) of curvature of the resonator mirror elements is or are designed in an adjusted manner to the expansion angle α of the atomic beam in such a way that a frequency shift due to the Doppler effect during the light absorption is minimized for preferably all atoms within the beam conus α.

4. Device according to claim 2, wherein the device according to the functioning principle of optical pumping comprises several common mirror elements (B.3', B.3"), wherein the angle under which the light source radiates in relation to the atomic beam conus is chosen with regard to the orientation of the mirror elements (B.3', B.3"), in such a way that a frequency shift due to the Doppler effect during the light absorption is minimized for preferably all atoms within the beam conus α.

5. Device according to claim 1, wherein separation magnets (B.10, B.10') or separation magnets and a high frequency transition device (H) are provided as polarization device (B), for example with a coil (H.1) in the area of the inhomogeneous magnetic field of the magnets (H.2, H.2').

6. Device according to any one of claims 1 to 5, wherein the absorption device (C) comprises at least one reservoir (C.5) arranged between the feed lines and the draining lines (C.1, C.1').

7. Device according to one any of the claims 1 to 6, equipped for active circulation of the liquid.

8. Device according to any one of claims 1 to 7, wherein the absorption device (C) comprises, at least in the area where the liquid is exposed to the atomic or ionic beam respectively, a cooling device (E), for instance a cooling plate placed opposite to the side exposed to the nuclear spin polarized radiation, the flow of liquid nitrogen or cold gas servingn as cooling means.

9. Device according to any one of claims 6, 7 or 8, wherein the absorption device (C) comprises a tappet for liquids (C.6), plunging into the reservoir (C.5) and being rotatable around an axis (C.7) for the creation of a film, and a liquid wiper (C.8) connected thereto, which gathers the polarized liquid film created in this way and leads it to the draining line.

10. Device according to any one of claims 1 to 9, comprising sources of magnetic fields (C.4) which generate a magnetic field in the intersection (2.X).

11. Device according to claim 10, wherein an ionisation device (F), e.g. comprising ionisation plates (F.1, F.1'), is situated in the direction of the beam between the polarization devise (B) and the absorption device (C) in such a way that polarized ions are absorbed within the liquid (C.2) wherein the ionisation plates are arranged within the magnetic field of the source of the magnetic field (C.4).

12. Device according to claim 11, wherein an electrostatic transport device (G), e.g. comprising an electrostatic net (G.1) and at least one electrostatic lens (G2), is provided in the direction of the beam between ionisation device (F) and absorption device (C) for directing the ions to the liquid (C.2) of the absorption device (C).

13. Device according to one of the claims 1 to 12, wherein at least one further aperture in the form of a revolver with pinholes (A.4) is arranged in the direction of the beam after the nozzle and the first aperture (A.2, A.3).

14. Method for the production of a liquid having a nuclear spin polarization by means of a device according to any one of claims 1 to 13, comprising the following steps:
a) providing a type of atom for generating the atomic beam and selecting a first liquid in which the T1-time for the nuclear spin polarized atoms of the atomic beam lasts more than one second,
b) Mixing a part of the first liquid with a liquid having a low vapour pressure, in such a way that the vapour pressure of the liquid mixture will not exceed 1 Pa (10⁻² mbar) at a temperature of 20°C of the mixture,
c) transfer of the liquid mixture into the device according to any one of claims 1 to 13, the liquid mixture being led through the feed lines into the absorption chamber,
d) exposure of the liquid mixture to the nuclear spin polarized atomic or ionic beam, with the ionisation device in the case of radiation with ions and, the surface of the liquid exposed to the atomic beam in the case of radiation with atoms being located within a magnetic field and the adiabaticity condition being satisfied for the nuclear spin polarized atoms or ions flying respectively through the magnetic field,
e) draining the irradiated and therefore polarized liquid mixture out of the device.

15. Method according to claim 14, wherein the polarizable liquid comprises a portion of H2O and/or D2O.

16. Method according to claims 14 or 15, wherein the polarizable liquid comprises a portion of an ionic liquid, particularly selected from the group of:
a) BMIM-Tf2N = ((1-butyl-3-methyl-imidazole)-(bis-trifluoromethyl-sulfonyl-amide)),
b) EMIM-BF4 = (1-ethyl-3-methyl-imidazole tetrafluoroborate) or
c) BMIM-PF6 = (1-butyl-3-methyl-imidazole hexafluorophosphate)

17. Method according to any one of claims 14 to 16, wherein the polarizable liquid is supplied or drained away either in portions or continually.

18. Method according to any one of claims 14 to 17, wherein, upon formation of ions, an accelerating potential is applied between the ionisation device (F) and the absorption device (C).

19. Method according to any one of claims 14 to 18, wherein the liquid to be polarized or/and the polarized liquid is cooled within the absorption device (C) in order to reduce the vapour pressure.

20. Method according to any one of claims 14 to 19, wherein the polarized portion of the liquid is enriched after the first and/or each subsequent radiation.

21. Method according to claim 20, wherein the enrichment is carried out by means of dilution or other chemical separation methods.

## Revendications

1. Dispositif de production pour un liquide avec des spins nucléaires polarisés, composé
- d'un appareillage sous vide comprenant une chambre d'émission (1) et une chambre d'absorption (2),
- d'un dispositif de pompe à vide (D),
- d'une source d'émission d'atomes (A.1), située dans la chambre d'émission, produisant un faisceau d'atomes,
- d'un dispositif de conduite du faisceau d'atomes comprenant au moins une tuyère et un diaphragme (A.2, A.3),
- d'un dispositif de polarisation (B) pour la polarisation de spin nucléaire des atomes du faisceau d'atomes, et éventuellement d'un dispositif d'ionisation pour l'ionisation des atomes polarisés,
- d'un dispositif d'absorption (C) avec des voies d'entrée et des voies de sortie (C.1, C.1'), servant à introduire le liquide à polariser dans la chambre d'absorption et à l'évacuer de nouveau après la polarisation par exposition aux atomes ou aux ions ayant un spin nucléaire polarisé.
le dispositif d'absorption êtant agencé soit de façon à ce que le liquide coulant de la voie d'entrée à la voie de sortie soit exposé au faisceau sans protection au niveau d'une zone de croisement (2.X) avec ledit faisceau formé d'atomes ou d'ions, soit de façon à ce que le liquide - dans le cas d'exposition aux ions - soit séparé au niveau de la zone de croisement (2.X) avec le faisceau d'ions du reste de la chambre d'absorption par une feuille que les ions pourront traverser et le liquide conduit à travers la chambre d'absorption forme un film liquide à l'arrière de la feuille.

2. Dispositif selon la revendication 1, comprenant comme dispositif de polarisation (B) un dispositif fonctionnant sur le principe de la pompe optique avec une source lumineuse focalisée sur les lignes d'absorption de l'atome à polariser.

3. Dispositif selon la revendication 2, d'après laquelle le dispositif fonctionnant selon le principe de la pompe optique comporte un résonateur optique formé par au moins deux éléments de résonateur réfléchissants (B.2, B.2'), dont un ou les deux rayons de courbure des éléments de résonateur réfléchissants sont réglés en fonction de l'angle d'élargissement α du faisceau d'atomes, et cela de manière à ce qu'un déplacement de fréquence par effet Doppler durant l'absorption lumineuse soit minimisé pour si possible tous les atomes se trouvant dans le cône α du faisceau.

4. Dispositif selon la revendication 2, dont le dispositif fonctionnant selon le principe de la pompe optique comporte plusieurs éléments réfléchissants habituels (B.3', B.3"), pour lesquels l'angle d'incidence de la source lumineuse en relation avec le cône du faisceau d'atomes, lié à l'orientation des éléments réfléchissants (B.3', B.3"), est choisi de façon à ce qu'un déplacement de fréquence par effet Doppler durant l'absorption lumineuse soit minimisé pour si possible tous les atomes se trouvant dans le cône α du faisceau.

5. Dispositif selon la revendication 1, comprenant comme dispositif de polarisation (B) des aimants de séparation (B.10, B.10') ou des aimants de séparation et un dispositif de passage à haute fréquence (H), par exemple avec une bobine (H.1) placée dans le champ magnétique non-homogène des aimants (H.2, H.2').

6. Dispositif selon l'une des revendications 1 à 5, dont le dispositif d'absorption (C) comporte au moins un réservoir entre les voies d'entrée et les voies de sortie (C.1, C.1').

7. Dispositif selon l'une des revendications 1 à 6, aménagé pour la circulation active du liquide.

8. Dispositif selon l'une des revendications 1 à 7, dont le dispositif d'absorption (C) comporte au moins, dans la zone dans laquelle le liquide est exposé au faisceau d'atomes ou d'ions, un dispositif de refroidissement (E), par exemple réalisé sous forme d'un tôle de refroidissement situé du côté opposé de la radiation à polarisation de spin nucléaire et dont un écoulement d'azote liquide ou de gaz froid est prévu comme moyen de refroidissement.

9. Dispositif selon l'une des revendications 6, 7 ou 8, dont le dispositif d'absorption (C) comprend un système à taquets d'entraînement du liquide (C.6) plongeant dans le réservoir (C.5) et tournant autour d'un axe (C.7) en vue de la formation d'un film et sur ledit système est monté un récupérateur de liquide (C.8), lequel récupère le film liquide polarisé formé pour le conduire jusqu'à la voie de sortie.

10. Dispositif selon l'une des revendications 1 à 9, comprenant des sources de champ magnétique (C.4), engendrant un champ magnétique dans la zone de croisement (2.X).

11. Dispositif selon la revendication 10, dont un dispositif d'ionisation (F), comprenant par exemple des tôles d'ionisation (F.1, F.1') situées à l'intérieur du champs magnétique de la source magnétique (C.4), est agencé dans le sens du faisceau entre le dispositif de polarisation (B) et le dispositif d'absorption (C) de manière à ce que des ions polarisés soient absorbés dans le liquide (C.2).

12. Dispositif selon la revendication 11, dont un dispositif de transport électrostatique (G), comprenant par exemple un réseau électrostatique (G.1) et au moins une lentille électrostatique (G.2), est prévu dans le sens du faisceau entre le dispositif d'ionisation (F) et le dispositif d'absorption (C) pour amener des ions au liquide (C.2) du dispositif d'absorption (C).

13. Dispositif selon l'une des revendications 1 à 12, dont au moins un autre diaphragme sous forme de revolver avec des sténopés (A.4) est agencé en direction du faisceau après la tuyère et le premier diaphragme (A.2, A.3).

14. Procédé de production d'un liquide avec des spins nucléaires polarisés moyennant un dispositif selon l'une des revendications 1 à 13 comprenant les étapes suivantes :
a) Mettre à disposition d'une sorte d'atomes pour la création du faisceau d'atomes et sélection d'un premier liquide, dans lequel le temps T1 pour les atomes avec des spins nucléaires polarisés du faisceau d'atomes s'élève à plus d'une seconde;
b) Mélanger une partie du premier liquide avec un liquide à faible pression de vapeur, de manière à ce que la pression de vapeur du mélange des liquides ne dépasse pas 1 Pa (10⁻² mbar) pour une température du mélange de 20°C;
c) Transférer le mélange des liquides dans le dispositif selon l'une des revendications 1 à 13, dont le mélange des liquides est conduit par la voie d'entrée dans la chambre d'absorption;
d) Exposer le mélange des liquides au faisceau d'atomes ou d'ions avec des spins nucléaires polarisés dont en cas d'irradiation avec des ions le dispositif d'ionisation et en cas d'irradiation avec des atomes, la surface du liquide exposée au faisceau d'atomes sont situés à l'intérieur d'un champs magnétique - la condition d'adiabaticité étant remplie pour les atomes ou ions avec des spins nucléaires polarisés traversant le champ magnétique;
e) Extraire le mélange des liquides qui a été irradié et ainsi polarisé hors du dispositif.

15. Procédé selon la revendication 14, dont le liquide polarisable comprend une part de H2O et/ou D2O.

16. Procédé selon la revendication 14 ou 15, dont le liquide polarisable comprend une part de liquide ionique, en particulier choisie du groupe:
a) BMIM-Tf2N = ((1-butyl-3-méthyle-imidazole)-(bis-trifluorométhyl-sulfonyl-amide)),
b) EMIM-BF4 = (1-éthyl-3-méthyle-imidazole tetrafluoroborate) ou
c) BMIM-PF6 = (1-butyl-3-méthyle-imidazole hexafluorophosphate).

17. Procédé selon l'une des revendications 14 à 16, dont le liquide polarisable est introduit et/ou évacué par portions ou en continu.

18. Procédé selon l'une des revendications 14 à 17, dont une tension accélératrice est établie entre le dispositif d'ionisation (F) et le dispositif d'absorption (C) dans le cas de production d'ions dans l'appareillage sous vide.

19. Procédé selon l'une des revendications 14 à 18, dont le liquide à polariser et/ou le liquide polarisé est refroidi à l'intérieur du dispositif d'absorption (C) afin de réduire la pression de vapeur.

20. Procédé selon l'une des revendications 14 à 19, dont le degré de polarisation du liquide est enrichi après la première irradiation et/ou chaque irradiation supplémentaire.

21. Procédé selon la revendication 20, dont l'enrichissement est réalisé par extraction ou autres procédés de séparation chimiques.
